(19) Europäisches Patentamt

European Patent Office

Office européen des brevets

(11) **EP 1 262 574 A2**

(12) **EUROPÄISCHE PATENTANMELDUNG**

(43) Veröffentlichungstag:
**04.12.2002 Patentblatt 2002/49**

(51) Int Cl.⁷: **C23C 14/35**, H01J 37/34

(21) Anmeldenummer: 02008963.7

(22) Anmeldetag: **22.04.2002**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI**<br><br>(30) Priorität: **23.04.2001 DE 10119834** | (71) Anmelder: **Fraunhofer-Gesellschaft zur Förderung der angewandten Forschung e.V. 80636 München (DE)**<br><br>(72) Erfinder:<br>• **Malkomes, Niels, Dr.**<br>  **38106 Braunschweig (DE)**<br>• **Vergöhl, Michael, Dr.**<br>  **38162 Destedt (DE)** |

(54) **Verfahren zur Stabilisierung von Sputterprozessen**

(57)    Die Erfindung betrifft ein Verfahren zur Stabilisierung eines Sputterprozesses, bei dem der Sputterprozess aus zwei DC-, MF-, oder RF- angeregter reaktiver Teil-Sputterprozessen A und B mit Sputterströme $I_A$ bzw. $I_B$ zusammengesetzt ist, bei dem eine Messung des Reaktivgaspartialdrucks und der Entladungsparameter vorgenommen wird, und bei dem aufgrund der Messresultate eine Prozessregelung der über den Reaktivgaspartialdruck gekoppelten Teilprozesse vorgenommen wird, und das

dadurch gekennzeichnet ist, dass die Prozessregelung derart erfolgt, dass

a) einer der Sputterströme $I_A$ oder $I_B$ ausgewählt und dessen Wert vorgegeben wird
b) der im Schritt a) nicht ausgewählte Sputterstrom oder der Reaktivgasfluss ausgewählt und dessen Wert vorgegeben wird
c) und die in Schritt b) nicht ausgewählte Größe dynamisch auf den Reaktivgaspartialdruck geregelt wird

EP 1 262 574 A2

**Beschreibung**

Die vorliegende Erfindung bezieht sich auf ein Verfahren zur Regelung von DC-, MF- oder RF-Sputterprozessen. Plasmasputtern ist eine etablierte Technologie für die Beschichtung von Substraten, insbesondere mit keramischen oder anderen mehrkomponentigen Funktionsschichten. Das Sputtern, insbesondere das reaktive Magnetronsputtern basiert auf dem Sputtern von metallischen Targets in einer reaktiven Atmosphäre mit dem Ziel, auf dem Substrat die gewünschte Verbindung mit der gewünschten Mikrostruktur und Phasenzusammensetzung bei hoher Rate aufwachsen zu lassen.

Zur Deposition von Mischoxiden $A_xB_yO_z$ (oder auch Nitriden etc.) der Metalle A und B können Mischtargets mit definierten Anteilen von A und B verwendet werden, was aber das Verhältnis von A und B in den Oxiden festlegt. Daher können auch zwei verschiedene Targets aus den Materialien A und B verwendet werden und die Stöchiometrie der Verbindung über den von den jeweiligen Targets emittierten Metallpartikelstrom und den Reaktivgaspartialdruck eingestellt werden.

Ein wesentliches Problem resultiert jedoch daraus, dass der Reaktivgas-Partialdruck in konventionellen Sputterprozessen nicht stetig verändert werden kann. Der Parameterraum zerfällt daher in die definierten Bereiche "Compound Mode" mit hohem Reaktivgas-Partialdruck und einer vollständig mit Reaktionsprodukten bedeckten Targetoberfläche sowie stöchiometrischen Schichten am Substrat und einem "Metallic Mode" mit einem geringen Reaktivgas-Partialdruck in der Sputterkammer, einer weitgehend metallischen Targetoberfläche und dem Aufwachsen von metallischen Schichten auf dem Substrat. Zwischen diesen Bereichen ist im allgemeinen kein stetiger Übergang möglich, es resultieren vielmehr instabile Prozesszustände, deren Zustandekommen im folgenden skizziert wird. Dabei wird beispielhaft auf das Reaktivgas $O_2$ Bezug genommen, die angeführten Mechanismen gelten jedoch auch für Sputtern in $N_2$, $CH_x$ und dgl.

Zu Beginn des Magnetronsputterns wird Reaktivgas in die Sputterkammer zugegeben. Daraufhin laufen auf der Targetoberfläche konkurrierende Wachstums- und Ätzprozesse ab. Bei niedrigem $O_2$-Partialdruck ist die Rate für das Aufwachsen der Oxidbedeckung gering, so dass der Ätzprozess durch den Sputterabtrag der Oxidschicht überwiegt. Die Targetoberfläche bleibt daher insgesamt metallisch. Dieser Zustand ist stabil, da das Target als effiziente Getterpumpe arbeitet, deren effektives Saugvermögen der eigentlich zur Evakuierung eingesetzten Turbopumpe beträgt.

Wird der Reaktivgas-Partialdruck erhöht, so wächst auf der Targetoberfläche eine Oxidschicht mit etwas höherer Rate auf. Bei geringen Ionenstromdichten und somit geringer Ärzrate überwiegt dann der Wachstumsprozeß. Auf diese Weise entstehen mit Reaktionsprodukten bedeckte Targetbereiche, die auch als "vergiftete Targetbereiche" bezeichnet werden.

Diese vergifteten Targetbereiche weisen gegenüber dem Metall stets eine geringere Sputterausbeute auf, so dass insgesamt weniger Targetmaterial gesputtert wird. Dies führt zu einer Abnahme des Materialabtrags am Target, einer Verminderung des Targetsaugvermögens und damit zu einer weiteren Erhöhung des Reaktivgas-Partialdrucks.

Sobald der Reaktivgas-Partialdruck einen kritischen Wert überschreitet, kommt es folglich zu einem selbstverstärkenden Effekt, da die Erhöhung des Reaktivgas-Partialdrucks eine Verminderung des Saugvermögens der Target-Getterpumpe zur Folge hat, woraus wiederum eine Erhöhung des Reaktivgas-Partialdrucks resultiert. Diese Instabilität kennzeichnet den Übergang vom Metallic Mode in den Compound Mode.

Technisch von großem Interesse ist nun gerade die Stabilisierung des unstetigen Übergangs zwischen diesen beiden Zuständen, da zum einen die Wachstumsrate im Compound Mode bedingt durch die niedrige Sputterausbeute nur gering ist, andererseits die Schichten im Compound Mode unter Reaktivüberschuss aufwachsen, woraus ungünstige Schichteigenschaften resultieren. Andererseits ist der Reaktivgas-Partialdruck im Metallic Mode im allgemeinen zu gering, so dass dann absorbierende unterstöchiometrische Verbindungen aufwachsen.

Die gewünschten stöchiometischen Schichten können jedoch dann bei hoher Rate abgeschieden werden, wenn der Prozess genau im instabilen Übergangsbereich, der auch als "Transition Mode" bezeichnet wird, betrieben wird. Die Stabilisierung dieses unstetigen Übergangszustandes "Transition Mode" ist durch Regelkreise möglich, die das dynamische Verhalten der Quellen berücksichtigen und die so die technisch interessanten instabilen Arbeitspunkte aufrechterhalten können.

Im Stand der Technik werden verschiedene Regelverfahren vorgeschlagen um den Transition Mode zu stabilisieren. Technisch etabliert ist vor allem die Regelung des Reaktivgasflusses nach Maßgabe der optischen Plasmaemission ausgewählter Spektrallinien, wobei der Reaktivgasfluss über schnell schaltende Piezoventile vorgeben wird.

Ebenfalls bekannt sind Impedanzregelungsvarianten, die entweder bei konstanter Leistung bzw. konstantem Sputterstrom anhand des Reaktivgasflusses, oder bei konstantem Reaktivgasfluss anhand des Entladungsstromes bzw. der Entladungsleistung eine Stabilisierung der Entladungsspannung vornehmen, vgl. hierzu die DD 146 306.

Ein weiteres industriell eingesetztes Verfahren ist die Regelung reaktiver Einzelprozesse zur Deposition oxidischer Schichten nach Maßgabe einer $O_2$-Partialdruckmessung mittels λ-Sonde durch die Anpassung der Entladungsleistung oder des Entladungsstroms, vgl. hierzu die EP 0 795 623 A1.

Den vorstehend genannten Regelverfahren ist gemeinsam, dass sie für Prozesse mit einer Kathode, und damit für Einzelprozesse, konzipiert sind. Sollen jedoch zwei verschiedene Targets A und B in einem Rezipienten Verwendung finden, wie es insbesondere für die vorstehend genannte Abscheidung von Mischoxiden erforderlich sein kann, so beeinflussen sich die Teilprozesse gegenseitig, so dass die bekannten Regelverfahren auf die Teilprozesse nicht mehr unabhängig voneinander angewendet werden können. Insofern sind die vorstehend genannten Regelverfahren für derartig gekoppelte Prozesse nicht bzw. nur noch sehr eingeschränkt anwendbar.

Dem Problem einer Regelung für ein aus zwei Teil-Sputterprozessen A und B zusammengesetzten Sputterprozess widmet sich Nyberg et al. in J. Vac. Sci. Technol. A 15(1), 145 (1997). In dieser Arbeit wird gelehrt, ein Zweitargetprozess bei konstanten Sputterströmen anhand der optischen Plasmaemission eines Teilprozesses über den Reaktivgasfluss zu regeln, was keine Aussage über den Prozeßzustand des zweiten Teilprozesses erlaubt. Daneben erscheint die Intensität der optischen Plasmaemission aufgrund der starken Abhängigkeit der Intensität von der Elektronendichte, welche wiederum stark vom Entladungsstrom abhängig ist, für verschiedenen Sputterströme schwer zu vergleichen.

Bekannt ist ferner die DD 15 78 08 die eine Regelung des Zweitarget-Sputterverfahrens dadurch vornimmt, dass zur Arbeitspunktstabilisierung für die beiden Teilprozesse der monotone U-I-Kennlinienverlauf des Targetmaterials dergestalt ausgenutzt wird, dass zur Einstellung eines definierten Reaktivgaspartialdrucks bei fester Kathodenspannung der Sputterstrom geregelt wird.

**Darstellung der Erfindung**

Der vorliegenden Erfindung liegt das technische Problem zugrunde, ein Verfahren zur Regelung von gekoppelten Sputterprozessen angeben, mit dem der Prozesszustand jedes Teilprozesses definiert eingestellt werden kann.

Ein weiteres technisches Problem besteht darin, dieses Regelverfahren für die verschiedensten Targetmaterialkombinationen universell einsetzbar zur Verfügung zu stellen.

Dieses technische Problem wird durch das Verfahren nach Anspruch 1 gelöst. Vorteilhafte Weiterbildungen des erfindungsgemäßen Verfahrens werden in den abhängigen Ansprüchen gegeben.

Erfindungsgemäß wurde erkannt, dass das vorstehend genannte technische Problem sich dadurch lösen lässt, dass ein Verfahren zur Stabilisierung eines Sputterprozesses bereeitgestellt wird, bei dem der Sputterprozess aus zwei DC-, MF-, oder RF- angeregter reaktiver Teil-Sputterprozesse A und B mit Sputterströme $I_A$ bzw. $I_B$ zusammengesetzt ist, bei dem eine Messung des Reaktivgaspartialdruckes und der Entladungsparameter vorgenommen wird, und bei dem aufgrund der Messresultate eine Prozessregelung der über den Reaktivgaspartialdruck gekoppelten Teilprozesse durchgeführt wird, wobei die Prozessregelung derart erfolgt, dass

    a) einer der Sputterströme $I_A$ oder $I_B$ ausgewählt und dessen Wert vorgegeben wird,

    b) der im Schritt a) nicht gewählte Sputterstrom oder der Reaktivgasfluss ausgewählt und dessen Wert vorgegeben wird,

    c) und die im Schritt b) nicht ausgewählte Größe dynamisch auf den Reaktivgaspartialdruck geregelt wird.

In einer Variante können somit die Ströme von den Kathoden der Teilprozesse A und B angepasst eingestellt werden, und der Reaktivgaspartialdruck dynamisch mit dem Gesamtreaktivgasfluss geregelt werden.

Alternativ wird der Gesamt-Reaktivgasfluss für beide Prozesse A und B vorgegeben, der Sputterstrom der Kathode für den Teilprozess A angepasst eingestellt und zur Stabilisierung des Reaktivgaspartialdruckes den Strom der Kathode von Teilprozess B dynamisch geregelt.

Der erfindungsgemäßen Regelung liegt hierbei folgende Erkenntnis zugrunde:

Der Gesamtreaktivgasfluss $f_{tot}$ verteilt sich auf den Prozess A, den Prozess B und den Vakuumpumpstand P. Für die Einzel-Sputterprozesse A bzw. B ist der effektiv vom System verbrauchte Reaktivgasfluss bei konstantem Sputterstrom $I_A$ bzw. $I_B$ nach dem Modell von Larsson (T. Larsson, H.-O. Blom, C. Nenders, S. Berg: J. Vac. Sci. Technol. A6, 1832, (1988)) eine eindeutige Funktion des Reaktivgaspartialdruckes $p_{O2}$ und damit von der Form $f_{O_2,Aeff}(p_{O_2})$ bzw. $f_{O_2,Beff}(p_{O_2})$. Der vom Pumpstand verbrauchte Reaktivgasfluss ist ebenfalls eindeutig vom Reaktivgaspartialdruck abhängig und damit von der Form $f_{O_2,P}(p_{O_2})$. Damit können die Arbeitspunkte für Prozess A und Prozess B mit der Einschränkung auf den gleichen Reaktivgaspartialdruck beliebig vorgegeben werden, in dem die Sputterströme und der gemeinsame Reaktivgaspartialdruck festgelegt werden. Der nötige Gleichgewichtsreaktivgasfluss ergibt sich dann in eindeutiger Weise als Summe des effektiv vom Prozess A, vom Prozess B und dem Vakuumpumpstand P bei diesen gegebenen Reaktivgaspartialdruck verbrauchten Reaktivgasfluss:

$$f_{O_2,tot}(p_{O_2})=f_{O_2,Aeff}(p_{O_2})+f_{O_2,Beff}(p_{O_2})+f_{O_2,P}(p_{O_2})$$

Aus dieser Erkenntnis ergibt sich die praktische Konsequenz, dass man die Targetzustände der beiden gekoppelten Sputterprozesse unabhängig voneinander einstellen kann. Der Arbeitspunkt von Teilprozess A kann man zunächst beliebig durch Vorgabe des Stromes $I_A$ und des Partialdrucks vorgeben. Der effektive Gleichgewichtsfluss für diesen Prozess alleine ist $f_{O_2,Aeff}(p_{O_2})$. Der Arbeitspunkt von Prozess B kann nun seinerseits aufgrund des des nun festgelegten Partialdrucks noch durch die Wahl des Stroms $I_B$ und des zugehörigen Gleichgewichtsflusses $f_{O_2,Beff}(p_{O_2})$ festgelegt werden. Für den Gesamtprozess müssen diese beiden Flüsse dann zum bei dem gegebenen Reaktivgaspartialdruck vom Pumpstand verbrauchten Fluss addiert und in die Kammer gegeben werden.

Die Stabilisierung des Reaktivgaspartialdrukkes kann dann zum einen dadurch erfolgen, dass die Ströme $I_A$ bzw.$I_B$ entsprechend vorgegeben werden und mit dem Reaktivgasfluss dynamisch auf den Reaktivgaspartialdruck geregelt wird. Alternativ kann der Reaktivgasfluss und der Strom eine Kathode ($I_A$ oder $I_B$) entsprechend vorgegeben werden und mit dem Strom der anderen Kathode der Reaktivgaspartialdruck stabilisiert werden.

Die erfindungsgemäße Regelung berücksichtigt die unumgängliche physikalische Kopplung der beiden Prozesse explizit und erlaubt es, die Arbeitspunkte für die beiden Prozesse beliebig einzustellen und zu stabilisieren. So ist es zum Beispiel möglich, den Prozess B im metallischen Bereich durchzuführen, und im Prozess A im Übergangsbereich. Selbstverständlich ist es auch möglich, beide Einzelprozesse A und B jeweils im Übergangsbereich ablaufen zu lassen. Zusammenfassend kann somit der Prozesszustand jedes Teilprozesses definiert eingestellt werden.

Ein weiterer Aspekt des Verfahrens ist vorgesehen, dass für die Targets der Teilprozesse A und B unterschiedliche Targetmaterialien Verwendung finden. Mit dem erfindungsgemäßen Verfahren lassen sich mittels unterschiedlicher Targetmaterialien Mischoxide des Typs $A_x,B_y,O_z$ oder auch Nitride etc. mit definierten Arbeitspunkten für die beiden Teilprozesse abscheiden. Wegen der universellen Einsetzbarkeit des Verfahrens lassen sich damit auch insbesondere Prozesse realisieren, bei denen kein monotoner U-I-Kennlinienverlauf vorliegt.

Vorteilhaft für die Verfahrensdurchführung ist hierbei, wenn ein Prozess mit einem großen Target mit konstantem großem Strom durch den Strom eines kleinen Targets mit kleinem Strom geregelt wird. Der sich damit einstellende Vorteil besteht darin, dass sich bei dieser Verfahrensdurchführung eine besonders gute Einstellbarkeit des Prozesszustandes des großen Targets und damit eine gute Regelbarkeit mit kleinen Zeitkonstanten ergibt. Damit kann eine präzise Einstellung der Prozessparameter in einem kritischen Prozessfenster erfolgen.

Günstig ist es ferner, zur Vorgabe der Arbeitspunkte der Teilprozesse die optische Emissionsspektroskopie verwendet wird. Der Vorteil liegt darin begründet, dass mit Hilfe der optischen Emissionsspektroskopie direkt der Zustand der Targetoberflächen (oxidisch, metallisch) sowie, mittels Intensitäten der Metall- oder Reaktivgaslinien, die Rate des abgesputterten Metalls oder des Metalloxids (bzw. der Verbindung des Metalls mit dem Reaktivgas) ermittelt werden kann. Die Arbeitspunkte der beiden konkurrierenden Prozesse können daher unabhängig voneinander sehr schnell eingestellt werden.

Von Vorteil für die industrielle Durchführung des Verfahrens ist es ferner, dass die Stöchiomentie und die Beschichtungsart in situ gemessen werden und zur Vorgabe der Arbeitspunkte der Teilprozesse verwendet werden.

Im industriellen Herstellungsprozess ist es nämlich erforderlich die Arbeitspunkte nachzuführen. Im Regelfall geschieht dies mit einem Operator, der aufgrund einer in situ oder Inline-Produktkontrolle die Arbeitspunkte nach heuristischen Regeln nachführt. Selbst schon in dieser Einstellungsphase der Beschichtungsanlage entsteht Ausschussmaterial, wobei die Menge des Ausschusses auch von der Qualifikation des Bedienpersonals abhängt. Daher ist es erstrebenswert einen Prozess bereitzustellen, der autonom den Arbeitspunkt einstellt und das gewünschte Produkt innerhalb der Toleranzen herstellt. Hierzu dient die in-situ-Messung der Stöchiometrie und der Beschichtungsrate um in diesem Sinne einen intelligenten Beschichtungsprozess für kostengünstiges Arbeiten bereitzustellen.

Für eine derartige in-situ-Messung besteht die beste Konfiguration zur Ausführung der Erfindung aus den folgenden Komponenten:

- Jeweils einem optischen Emissionsmonitor für jedes Target, der jeweils die Metall- und die Reaktivgaslinie erfasst;

- Einem Monitor zur Messung des Reaktivgas-Partialdruckes; vorzugsweise einer Lambda-Sonde zur Messung des Reaktivgas-Partialdruckes in der Kammer

- einer Regelschleife für die Einstellung und Kontrolle der Arbeitspunkte, sowie

- einem Monitor (vorzugsweise ein Ellipsometer, ein Photometer oder ein Schwingquarz) zur on-line Bestimmung der Stöchiometrie und der Beschichtungsrate der Schicht am Ort des Substrates. Die Erfassung durch den Monitor kann vorzugsweise in-situ direkt am Ort des Substrates und am Ort oder in der Nähe der Beschichtung, andernfalls aber auch ausserhalb der Beschichtungsanlage, jedoch zeitnah am Prozess, erfolgen.

Die Beschichtung kann beispielsweise in einer Drehtelleranlage erfolgen, wobei sich das Substrat auf einem Drehteller rotierend unter den jeweiligen Beschichtungsstationen (Targets) hinweg bewegt. Durch Einsatz von Doppelmagnetrons und unterschiedlichen Kathoden wird mit jedem Durchlauf eine Mischschicht abgeschieden, deren Zusammensetzung beim nächsten Durchlauf geändert werden kann. Auch ist die Beschichtung in einer in-line-Anlage oder in einer Trommelbeschichtungsanlage möglich, wobei wieder vorzugsweise Doppelmagnetrons eingesetzt werden, bei denen die beiden Targets jeweils aus unterschiedlichem Material bestehen. Das Substrat kann sich auch ständig im Bereich der Beschichtungszone befinden, so dass die Zusammensetzung der Schicht kontinuierlich während der Beschichtung verändert werden kann, so dass beispielsweise Gradientenschichten oder noch komplexere Funktionsschichten hergestellt werden können.

**Bester Weg sur Ausführung der Erfindung**

Figur 1 zeigt Ergebnisse einer Modellrechnung im Hinblick auf die zeitliche Entwicklung der relevanten Parameter zwei gekoppelter reaktiver Sputterprozesse.

Figuren 2 und 3 zeigen die zur Modellrechnung gemäß Figur 1 korrespondierenden stationären Kurven und Regeltrajektorien.

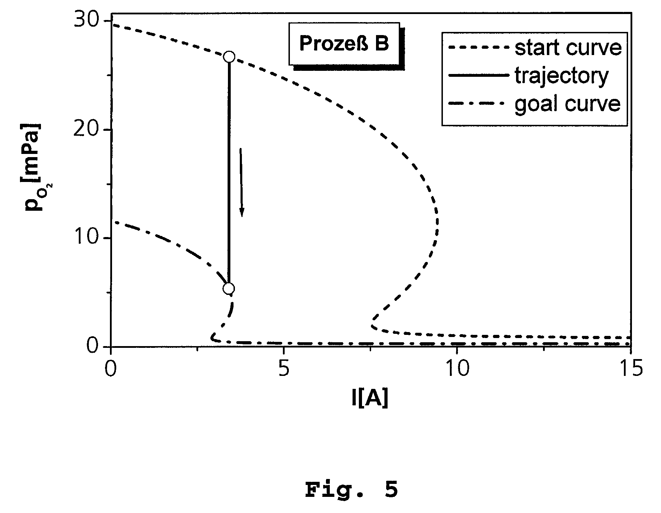

Figuren 4 und 5 zeigen für die Modellrechnung die Einstellungsmöglichkeiten für unterschiedliche Prozesszustände für die beiden Teilsysteme.

Figur 6 veranschaulicht die experimentell ermittelte Kopplung zweier reaktiver über den Reaktivgaspartialdruck gekoppelter Prozesse.

1. Simulation des Regelverfahrens

Zunächst wurden Modellrechnungen mit dem Larssonmodell durchgeführt. Die dynamische Simulation erfolgte mit entsprechender Erweiterung auf zwei gekoppelte Targets.

Die Simulation erfolgte mit zwei gleichen Prozessen mit gleichen Targets und gleich großen Behälterwandflächen. Mit gleichen Sputterströmen $I_A = I_B$ sollte dieses System äquivalent zu einem Einzelsystem mit der gleichen Gesamtfläche und dem doppeltem Strom sein. Die Startwerte wurdender dynamischen Simulation wurden aus dem stationären Larsson-Modell berechnet.

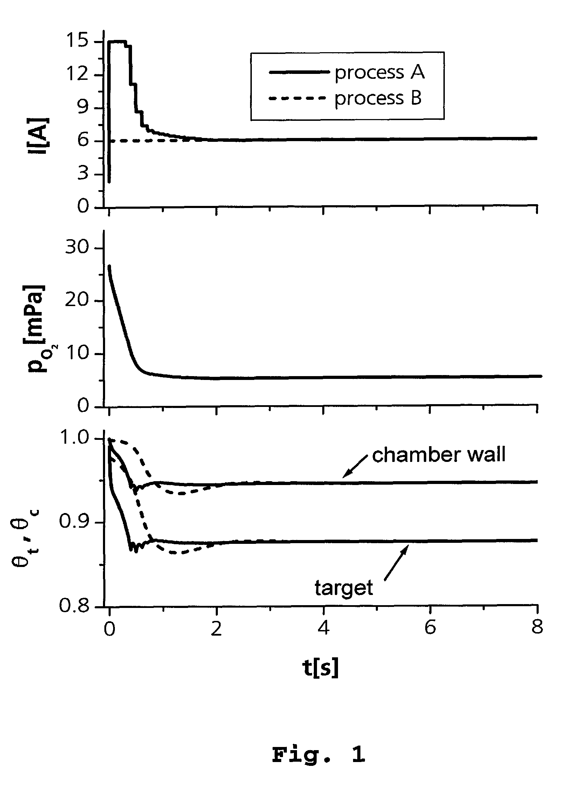

Die Zeitentwicklung von Strom I, Reaktivgaspartialdruck $p_{O_2}$, Kammer- und Targetbedeckung $\theta c$ bzw. $\theta_t$ zeigt hierbei die **Fig. 1**.

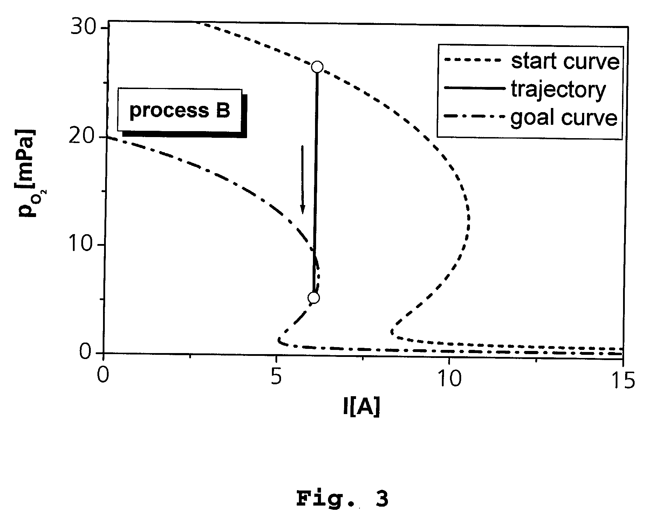

Der Strom von Prozess B wurde fixiert, und mit Hilfe des Stroms von Prozess A bei konstant gehaltenen Gesamt-Reaktivgasfluss auf den Sollreaktivgaspartialdruck $p_{O_2}$ geregelt. Der Prozess B wird hierdurch vom Oxid-Mode in den instabilen Übergangsmode gezwungen, was in **Fig. 3** durch den senkrecht nach unten gerichteten Pfeil angedeutet ist. Die Ströme und der Sollpartialdruck wurden hierbei so gewählt, dass beide Prozesse in den gleichen Prozesszustand überführt wurden, d.h. der variable Strom von Prozess A ist der gleiche wie der zuvor eingestellte Strom vom System B, vgl. **Fig. 1** oben.

Anschaulich gesprochen kann die Regelung des Prozesses A anhand des Stromes bei konstantem Reaktivgasfluss als Gasflusskontrolle für den bei konstantem Strom betriebenen Prozess B interpretiert werden.

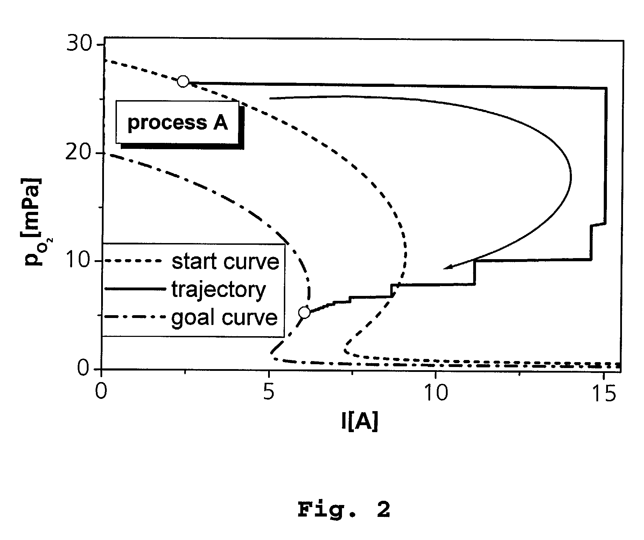

Die zugehörigen stationären Kurven und Regeltrajektorien zeigen die Figuren 2 und 3.

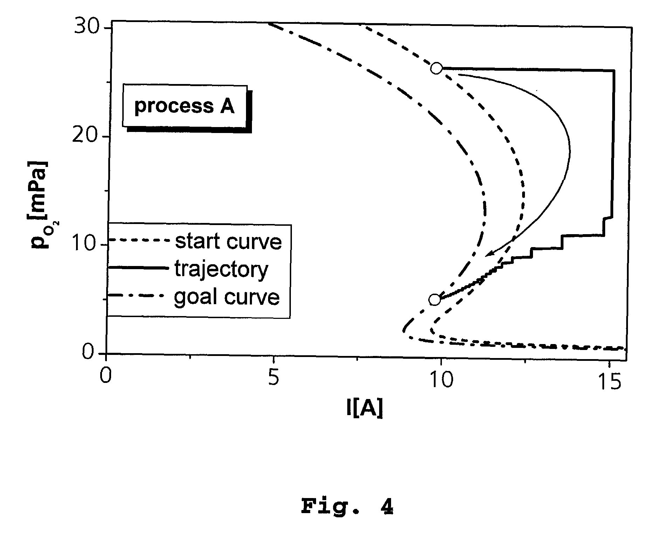

Auf die geschilderte Weise können die Prozesszustände der beiden Teilprozesse unabhängig von einander eingestellt werden. So kann z. B. der Prozess A durch entsprechende Wahl des Sputterstromes $I_A$ und des Sollpartialdrucks $p_O$ im Oxid-Mode betrieben werden, wohingegen der Prozess B im Transition Mode oder in Metallic Mode betrieben wird. Dies ist in **Fig. 3** und **Fig. 4** gezeigt.

2. Experimentelle Realisierung des Regelverfahrens

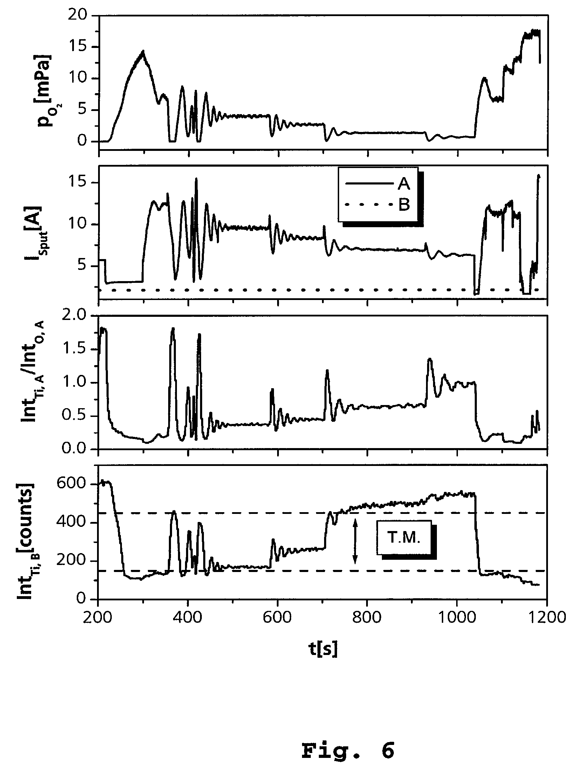

In einem Experiment wurden zwei reaktive Sputterprozesse A und B innerhalb ein und desselben Rezipienten durchgeführt, und die Ergebnisse des Experimentes sind in **Fig. 6** dargestellt. Innerhalb einer Balzers/Pfeiffer PLS 580-Batchanlage mit zwei PK 500 MF-Magneton Sputterkathoden wurden zwei über den Reaktivgaspartialdruck gekoppelte reaktive $TiO_2$-Prozesse betrieben, und zwar ein DC-Prozesses (Prozess B) auf der Seite des Rezipienten und eines MF-Prozesses (Prozess A) auf der anderen Seite des Rezipienten.

Die Targets hatten eine Größe von 488x88 $mm^2$ bei einer Dicke von 6 mm und befanden auf einem Glassubstrat welches in einen geerdeten Substrathalter eingebaut war. Der Strom des DC-Prozesses betrug konstant 2,1 Ampere bei einer typischen Leistung des DC-Prozess von 1 bis 2 kW. Der Strom bzw. die Leistung des MF-Prozesses wurde auf den Reaktivgaspartialdruck geregelt. Die Leistung des MF-Prozesses betrug hierbei typischerweise 2 bis 6 kW.

Der gewählte Gesamtreaktivgasfluss (Reaktivgas: $O_2$) betrug bei diesem Ausführungsbeispiel 15 sccm. Hierbei steht "sccm" für einen Gasfluss in Kubikcentimeter pro Minute unter den Standardbedingungen 1 bar und 20°C. Zusätzlich wurde Argon als Trägergas verwendet, und zwar mit einem Gasfluss von 30 sccm für den DC-Prozess und 60 sccm für den MF-Prozess.

Der Strom des einen Prozesses B und der Gesamtreaktivgasfluss wurde fixiert, und anhand des Stroms des zweiten Prozesses A wurde auf den Reaktivgaspartialdruck geregelt.

Die Messung des Reaktivgaspartialdrucks erfolgte mit einer λ-Sonde, der das Prozessgas über eine spezielle Gaszufuhr zugeführt wird. Die Messungen der optischen Plasmaemissionslinien erfolgte mit einem Gitterspektrographen und einem CCD-Sensor.

**Fig. 6** zeigt von oben nach unten den zeitlichen Ablauf

- des (integralen) Reaktivgaspartialdrucks $p_{O_2}$

- die beiden Sputterströme $I_{Sputt}$ für beide Prozesse A und B

- von Prozess A das Intensitätsverhältnis der Plasma-Emissionslinien von Titan (625,9 nm) und Sauerstoff (777,4 nm), sowie

- die Intensität der Titanlinie im Prozess B

Die Intensität der Titanlinie im DC-Prozess nach dem untersten Grafen von **Fig. 6** unten ist ein Maß dafür, ob der DC-Prozess im Oxide-Mode (0...150 counts), im Transition-Mode "T.M." (150...450 counts) oder im Metallic-Mode (450...600 counts) betrieben wird. Mit fortschreitender Zeit wurden ausgehend vom Metallic-Mode beider Prozesse diese in den Oxide-Mode überführt und dann sukzessive durch Absenken des Sauerstoffpartialdruckes in Richtung Metallic-Mode geregelt. Der DC-Prozesszustand konnte somit durch die Regelung auf der MF-Seite beliebig zwischen Oxide-Mode und Transition-Mode eingestellt werden. Anschließend werden beide Prozesse wieder in den Oxide-Mode überführt.

Zum Vergleich der Prozesszustände des in diesem Ausführungsbeispiel indirekt geregelten DC-Prozesses bei konstantem Strom wurde somit die Intensität der optischen Plasmaemission herangezogen, wobei sich gezeigt hat, dass der Prozess B indirekt über dem Prozess A prinzipiell beliebig zwischen Oxid-Mode und Metallic-Mode eingestellt werden kann.

Insbesondere zeigt sich vorteilhaft, dass auch der Bereich des Übergangsbereiches ("transition mode", = T.M.), welcher technisch besonders interessant ist, weil er hohe Raten bei gewünschter Stöchiometrie liefert, geregelt werden kann. Dies ist daran erkennbar, dass die Intensität der Plasmaemission im untersten Bild von **Fig. 4** im Bereich zwischen 150 und 450 Counts (getrichelter Bereich) gehalten werden kann.

Durch die Wahl des Stromes im Prozess A und des Reaktivgaspartialdruckes und des dazugehörigen Reaktivgasflusses können auf diese Weise die Arbeitspunkte für beide Prozesse beliebig eingestellt und stabilisiert werden.

**Patentansprüche**

1. Verfahren zur Stabilisierung eines Sputterprozesses, bei dem der Sputterprozess aus zwei DC-, MF-, oder RFangeregter reaktiver Teil-Sputterprozessen A und B mit Sputterströme $I_A$ bzw. $I_B$ zusammengesetzt ist, bei dem eine Messung des Reaktivgaspartialdrucks und der Entladungsparameter vorgenommen wird, und bei dem aufgrund der Messresultate eine Prozessregelung der über den Reaktivgaspartialdruck gekoppelten Teilprozesse vorgenommen wird,
**dadurch gekennzeichnet,**
**dass** die Prozessregelung derart erfolgt, dass

a.) einer der Sputterströme $I_A$ oder $I_B$ ausgewählt und dessen Wert vorgegeben wird

b.) der im Schritt a) nicht ausgewählte Sputterstrom oder der Reaktivgasfluss ausgewählt und dessen Wert vorgegeben wird

c.) und die in Schritt b) nicht ausgewählte Größe dynamisch auf den Reaktivgaspartialdruck geregelt wird

2. Verfahren nach Anspruch 1, **dadurch gekennzeichnet, dass** für die Targets der Teilprozesse A und B unterschiedliche Targetmaterialien Verwendung finden.

3. Verfahren nach Anspruch 1 oder 2, **dadurch gekennzeichnet, dass** ein Prozess mit einem großen Target mit konstantem großen Strom durch den Strom eines kleinen Targets mit kleinem Strom geregelt wird.

4. Verfahren nach einem der Ansprüche 1 bis 3, **dadurch gekennzeichnet, dass** zur Vorgabe der Arbeitspunkte der Teilprozesse die optische Emissionsspektroskopie verwendet wird.

5. Verfahren nach einem der Ansprüche 1 bis 4, **dadurch gekennzeichnet, dass** die Stöchiometrie und die Beschichtungsrate in situ gemessen werden und zur Vorgabe der Arbeitspunkte der Teilprozesse verwendet werden.

Fig. 1

Fig. 2

Fig. 3

Fig. 4

Fig. 5

Fig. 6